# EUROPÄISCHE PATENTANMELDUNG

(11) **EP 3 958 302 A1**
(43) Veröffentlichungstag der Anmeldung: **23.02.2022**
(21) Anmeldenummer: 20191358.9
(22) Anmeldetag: 17.08.2020
(51) Int. Cl.: H01L 23/13

(54) **BODENPLATTE FÜR EIN HALBLEITERMODUL UND VERFAHREN ZUM HERSTELLEN EINER BODENPLATTE**

(71) Anmelder: Infineon Technologies AG, 85579 Neubiberg (DE)
(72) Erfinder: UNRAU, Arthur, 59590 Geseke (DE); KÜHLE, Elmar, 59581 Warstein (DE)
(74) Vertreter: Westphal, Mussgnug & Partner, Patentanwälte mbB

(57) **Zusammenfassung**

Eine Bodenplatte (30) für ein Halbleitermodul weist wenigstens eine Erhebung (34) auf. Die wenigstens eine Erhebung (34) ist einstückig mit der Bodenplatte (30) ausgebildet. Die Bodenplatte (30) weist eine gleichmäßige erste Dicke (d30) oder eine sich von den Randbereichen zur Mitte hin kontinuierlich verringernde Dicke (d30) auf, welche im Bereich jeder der wenigstens einen Erhebung (34) lokal bis zu einer maximalen zweiten Dicke (d34) erhöht ist.

## Beschreibung

Die vorliegende Erfindung betrifft eine Bodenplatte für ein Halbleitermodul sowie ein Verfahren zum Herstellen einer solchen Bodenplatte.

Leistungshalbleitermodule weisen meist ein oder mehrere Halbleitersubstrate auf, die auf einer Bodenplatte angeordnet sind. Eine Halbleiteranordnung mit einer Vielzahl steuerbarer Halbleiterbauelemente (z.B. IGBTs) ist auf wenigstens einem der Substrate angeordnet. Ein Halbleitersubstrat weist in der Regel eine elektrisch isolierende Substratschicht (z.B. eine Keramikschicht), eine erste elektrisch leitende Schicht (z.B. eine Metallschicht) die auf einer ersten Seite der Substratschicht angeordnet ist, und eine zweite elektrisch leitende Schicht (z.B. eine Metallschicht) auf, die auf einer der ersten Seite gegenüberliegenden zweiten Seite der Substratschicht angeordnet ist. Die steuerbaren Halbleiterbauelemente sind beispielsweise auf der ersten elektrisch leitenden Schicht angeordnet. Die zweite elektrisch leitende Schicht ist meistens mit der Bodenplatte verbunden, das heißt, dass diese zwischen der Bodenplatte und der isolierenden Substratschicht angeordnet ist.

Zwischen dem Halbleitersubstrat, insbesondere der zweiten elektrischen leitenden Schicht, und der Bodenplatte ist meist eine Lotschicht angeordnet. Diese ist zum einen dazu ausgebildet, das Halbleitersubstrat mechanisch mit der Bodenplatte zu verbinden. Zum anderen wird über die Lotschicht auch Wärme abgeleitet, welche während des Betriebs der Halbleiteranordnung erzeugt wird.

Um einerseits eine stabile mechanische Verbindung zwischen dem Halbleitersubstrat und der Bodenplatte, und andererseits eine optimale Wärmeabfuhr zu gewährleisten, kann sichergestellt werden, dass die Lotschicht eine minimale Dicke nicht unter- und eine maximale Dicke nicht überschreitet. Weiterhin kann sichergestellt werden, dass die Lotschicht über die gesamte Fläche der Bodenplatte eine gleichmäßige Dicke aufweist.

Es besteht daher Bedarf an einer Bodenplatte und einem Verfahren zum Herstellen einer Bodenplatte, mit welcher ein Abstand zwischen der Bodenplatte und einem darauf angeordneten Halbleitersubstrat und somit die Dicke einer dazwischen befindlichen Lotschicht gezielt eingestellt werden kann.

Eine Bodenplatte für ein Halbleitermodul weist wenigstens eine Erhebung auf. Die wenigstens eine Erhebung ist einstückig mit der Bodenplatte ausgebildet. Die Bodenplatte weist eine gleichmäßige erste Dicke oder eine sich von den Randbereichen zur Mitte hin kontinuierlich verringernde Dicke auf, welche im Bereich jeder der wenigstens einen Erhebung lokal bis zu einer maximalen zweiten Dicke erhöht ist.

Ein Verfahren weist das Herstellen einer Bodenplatte mit einer gleichmäßigen ersten Dicke oder einer sich von den Randbereichen zur Mitte hin kontinuierlich verringernden Dicke, und das lokale Erhöhen der ersten Dicke bis zu einer maximalen zweiten Dicke im Bereich wenigstens einer Erhebung auf, wobei die wenigstens eine Erhebung einstückig mit der Bodenplatte ausgebildet ist.

Eine Anordnung weist wenigstens ein Substrat, eine Verbindungsschicht, und ein Bodenplatte auf, wobei das wenigstens eine Substrat auf der Bodenplatte angeordnet ist, und die Verbindungsschicht zwischen dem wenigstens einen Substrat und der Bodenplatte angeordnet ist und diese miteinander verbindet.

Die Erfindung wird nachfolgend anhand von Beispielen und Bezugnahme auf die Figuren näher erläutert. Dabei bezeichnen gleiche Bezugszeichen gleiche Elemente. Die Darstellung in den Figuren ist nicht maßstäblich.
Figur 1 zeigt schematisch einen Querschnitt durch eine Bodenplatte mit einem darauf angeordneten Substrat;
Figur 2 , umfassend die Figuren 2A und 2B, zeigt beispielhaft einen Querschnitt durch eine vorgekrümmte Bodenplatte mit einem darauf anzuordnenden Substrat;
Figur 3 zeigt schematisch einen Querschnitt durch eine Bodenplatte gemäß einem Beispiel;
Figur 4 zeigt schematisch einen Querschnitt durch eine herkömmliche Bodenplatte;
Figur 5 zeigt schematisch einen Querschnitt durch eine Bodenplatte gemäß einem weiteren Beispiel;
Figur 6 zeigt schematisch einen Querschnitt durch eine Bodenplatte gemäß einem weiteren Beispiel;
Figur 7 zeigt schematisch eine Draufsicht auf eine Bodenplatte mit integrierten Erhebungen gemäß einem Beispiel; und
Figur 8 zeigt schematisch eine Draufsicht auf eine Bodenplatte mit integrierten Erhebungen gemäß einem weiteren Beispiel.

In der nachfolgenden ausführlichen Beschreibung wird anhand konkreter Beispiele veranschaulicht, wie die Erfindung realisiert werden kann. Es versteht sich, dass die Merkmale der verschiedenen hierin beschriebenen Beispiele, sofern nicht anderweitig erwähnt, miteinander kombiniert werden können. Sofern bestimmte Elemente als "erstes Element", "zweites Element",... oder dergleichen bezeichnet werden, dient die Angabe "erstes", "zweites",... lediglich dazu, verschiedene Elemente voneinander zu unterscheiden. Eine Reihenfolge oder Aufzählung ist mit dieser Angabe nicht verbunden. Das bedeutet, dass beispielsweise ein "zweites Element" auch dann vorhanden sein kann, wenn kein "erstes Element" vorhanden ist.

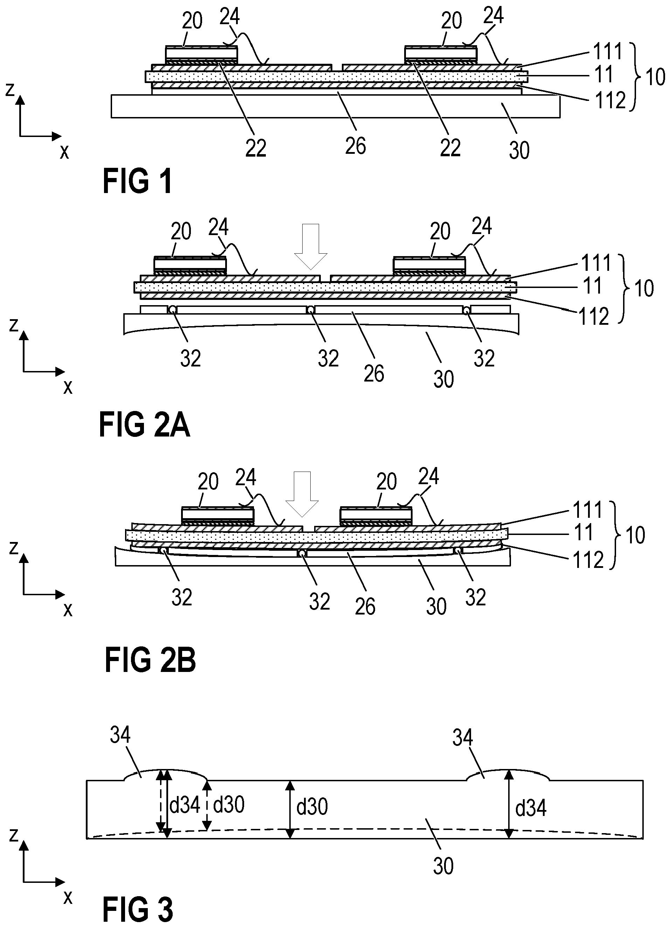

Bezugnehmend auf Figur 1 ist ein Halbleitersubstrat 10 dargestellt. Das Halbleitersubstrat 10 weist beispielsweise eine dielektrische Isolationsschicht 11, eine (strukturierte) erste elektrisch leitende Schicht 111 und eine (strukturierte) zweite elektrisch leitende Schicht 112 auf. Die erste elektrisch leitende Schicht 111 ist auf einer ersten Seite der dielektrischen Isolationsschicht 11 angeordnet und die zweite elektrische leitende Schicht 112 ist auf einer der ersten Seite gegenüberliegenden zweiten Seite der dielektrischen Isolationsschicht 11 angeordnet. Die dielektrische Isolationsschicht 11 ist somit zwischen der ersten elektrisch leitenden Schicht 111 und der zweiten elektrisch leitenden Schicht 112 angeordnet. Die zweite elektrisch leitende Schicht ist dabei jedoch lediglich optional. Es ist ebenso möglich, lediglich die erste elektrisch leitende Schicht 111 auf der dielektrischen Isolationsschicht 11 anzuordnen und die zweite elektrisch leitende Schicht 112 ganz wegzulassen.

Jede der ersten elektrisch leitenden Schicht 111 und der zweiten elektrisch leitenden Schicht 112 kann aus einem der folgenden Materialien bestehen oder eines der folgenden Materialien aufweisen: Kupfer; eine Kupferlegierung; Aluminium; eine Aluminiumlegierung; jegliches andere Metall oder jegliche andere Metalllegierung welche während des Betriebs des Leistungshalbleitermoduls in einem festen Zustand verbleibt. Das Halbleitersubstrat 10 kann ein keramisches Substrat sein, das heißt, ein Substrat bei welchem die dielektrische Isolationsschicht 11 aus Keramik besteht. Die dielektrische Isolationsschicht 11 kann somit beispielsweise eine dünne Keramikschicht sein. Die Keramik der dielektrischen Isolationsschicht 11 kann beispielsweise aus einem der folgenden Materialien bestehen oder eines der folgenden Materialien aufweisen: Aluminiumoxid; Aluminiumnitrid; Zirkoniumoxid; Siliziumnitrid; Bornitrid; oder jegliche andere Keramik. Beispielsweise kann die dielektrische Isolationsschicht 11 aus einem der folgenden Materialien bestehen oder eines der folgenden Materialien aufweisen: Al₂O₃, AlN, oder Si₃N₄. Das Halbleitersubstrat 10 kann beispielsweise ein so genanntes Direct Copper Bonding (DCB) Substrat, ein Direct Aluminium Bonding (DAB) Substrat, ein Insulated Metal Substrat (IMS) oder ein Active Metal Brazing (AMB) Substrat sein. Das Halbleitersubstrat 10 kann beispielsweise auch eine herkömmliche Leiterplatte (PCB, printed circuit board) sein mit einer nichtkeramischen dielektrischen Isolationsschicht 11. Eine nicht-keramische dielektrische Isolationsschicht 11 kann beispielsweise aus einem gehärteten Harz bestehen oder ein gehärtetes Harz aufweisen.

Weiterhin bezugnehmend auf Figur 1 können ein oder mehrere Halbleiterkörper 20 auf dem Halbleitersubstrat 10 angeordnet sein. Jeder der Halbleiterkörper 20 auf dem Halbleitersubstrat 10 kann eine Diode, einen IGBT (Bipolartransistor mit isolierter Gate-Elektrode), einen MOSFET (Metall-Oxid-Halbleiter-Feldeffekttransistor), einen JFET (Sperrschicht-Feldeffekttransistor), einen HEMT (Transistor mit hoher Elektronenbeweglichkeit), oder jegliches andere geeignete steuerbare Halbleiterbauelement aufweisen. Der eine oder die mehreren Halbleiterkörper 20 können auf dem Halbleitersubstrat 10 eine Halbleiteranordnung bilden. In Figur 1 sind beispielhaft lediglich zwei Halbleiterkörper 20 dargestellt.

Die in Figur 1 dargestellte erste elektrisch leitende Schicht 111 ist eine strukturierte Schicht. "Strukturierte Schicht" bedeutet in diesem Zusammenhang, dass die erste elektrisch leitende Schicht 111 keine durchgehende Schicht ist, sondern Unterbrechungen zwischen verschiedenen Abschnitten der Schicht aufweist. Verschiedene Halbleiterkörper 20 können auf dem selben Abschnitt oder auf unterschiedlichen Abschnitten der ersten elektrisch leitenden Schicht 111 angeordnet sein. Die verschiedenen Abschnitte der ersten elektrisch leitenden Schicht 111 können entweder keine elektrische Verbindung untereinander aufweisen oder können, z.B. mittels Bonddrähten, elektrisch miteinander verbunden sein. Jeder der Halbleiterkörper 20 kann mit dem Halbleitersubstrat 10 mittels einer elektrisch leitenden Verbindungsschicht 22 elektrisch und mechanisch verbunden sein. Figur 1 zeigt beispielhaft ein Halbleitersubstrat 10 mit darauf angeordneten Verbindungsschichten 22. Eine solche elektrisch leitende Verbindungsschicht 22 kann grundsätzlich eine Lötschicht, eine Schicht aus einem elektrisch leitenden Klebstoff oder eine Schicht aus einem gesinterten Metallpulver sein, z.B. einem gesinterten Silberpulver.

Die erste elektrisch leitende Schicht 111 kann grundsätzlich jedoch auch eine durchgehende Schicht sein. Die zweite elektrisch leitende Schicht 112 (sofern vorhanden) kann entweder eine durchgehende oder ebenfalls eine strukturierte Schicht sein.

Um die Halbleiterkörper 20 mit dem Halbleitersubstrat 10 zu verbinden, werden die Halbleiterkörper 20 auf der Oberfläche (obere Oberfläche) des Halbleitersubstrates 10 angeordnet, wobei die Verbindungsschicht 22 zwischen dem Halbleitersubstrat 10 und dem Halbleiterkörper 20 angeordnet ist. Die obere Oberfläche des Halbleitersubstrats 10 ist eine Oberfläche der ersten elektrisch leitenden Schicht 111, welche von der dielektrischen Isolationsschicht 11 abgewandt ist. Die Halbleiterkörper 20 können mit dem Halbleitersubstrat 10 alternativ oder zusätzlich beispielsweise auch mittels Bonddrähten 24 verbunden sein.

Das Halbleitersubstrat 10 mit dem wenigstens einen darauf angeordneten Halbleiterkörper 20 kann beispielsweise Teil eines Leistungshalbleitermoduls sein und in einem (nicht dargestellten) Gehäuse angeordnet sein.

Das Halbleitersubstrat 10 ist auf einer Bodenplatte 30 angeordnet. Die Bodenplatte 30 kann beispielsweise eine metallische Bodenplatte sein. Während in Figur 1 ein einziges Halbleitersubstrat 10 auf der Bodenplatte 30 angeordnet ist, ist es grundsätzlich auch möglich, mehr als ein Halbleitersubstrat 10 auf der selben Bodenplatte 30 anzuordnen. Eine Verbindungsschicht 26 ist zwischen dem Halbleitersubstrat 10 und der Bodenplatte 30 angeordnet. Die Verbindungsschicht 26 verbindet das Halbleitersubstrat 10 und die Bodenplatte 30 mechanisch miteinander. Ebenso ist es möglich, dass die Verbindungsschicht 26 eine elektrische Verbindung zwischen dem Halbleitersubstrat 10 und der Bodenplatte 30 herstellt. Die Verbindungsschicht 26 kann beispielsweise eine Lötschicht, eine Schicht aus einem elektrisch leitenden Klebstoff oder eine Schicht aus einem gesinterten Metallpulver sein, z.B. einem gesinterten Silberpulver.

Die Bodenplatte 30 kann beispielsweise auf einem Kühlkörper (nicht dargestellt) angeordnet sein. Im Betrieb der Halbleiteranordnung wird in der Regel Wärme erzeugt. Diese Wärme kann über das Halbleitersubstrat 10, die Verbindungsschicht 26 und die Bodenplatte 30 zu einem Kühlkörper abgeleitet werden. Die Verbindungsschicht 26 und die Bodenplatte 30 weisen daher in der Regel eine gute thermische Leitfähigkeit auf.

Um zum einen eine stabile mechanische Verbindung zwischen dem Halbleitersubstrat 10 und der Bodenplatte 30 und zum anderen eine gute thermische Leitfähigkeit zu gewährleisten, weist die Verbindungsschicht 26 in der Regel eine Dicke auf, welche eine bestimmte minimale Dicke nicht unter-, und eine bestimmte maximale Dicke nicht überschreitet.

Bodenplatten 30 können beispielsweise eine bestimmte Vorkrümmung aufweisen. Es ist jedoch auch möglich, dass eine Bodenplatte 30 vor dem Verbinden mit dem Halbleitersubstrat 10 eine im Wesentlichen ebene erste Oberfläche und eine der ersten Oberfläche gegenüberliegende gekrümmte zweite Oberfläche aufweist (oft auch als D-Shape bezeichnet). Dies ist beispielhaft in Figur 2 dargestellt. Wie in Figur 2A dargestellt, kann das Halbleitersubstrat 10 zunächst, also vor dem Verbinden mit der Bodenplatte 30, eine flache erste und eine gekrümmte zweite Oberfläche aufweisen. Beim Verbinden mit der Bodenplatte 30 (Andrücken des Substrats 10 an die Bodenplatte 30) können sich jedoch das Halbleitersubstrat 10 und die zuvor ebene erste Oberfläche der Bodenplatte 30 aufgrund der meist unterschiedlichen Ausdehnungskoeffizienten krümmen (vgl. Figur 2B). Gleichzeitig kann die ursprünglich gekrümmte zweite Oberfläche der Bodenplatte 30 durch die in der Bodenplatte 30 (insbesondere der ersten Oberfläche) erzeugte Krümmung in einer anschließend im Wesentlichen ebenen zweiten Oberfläche resultieren (vgl. Figur 2B). Um beim Verbinden des Halbleitersubstrats 10 mit der Bodenplatte 30 eine Krümmung des Halbleitersubstrats 10 und eine Dicke der Verbindungsschicht 26 gezielt einstellen zu können, sind häufig Abstandshalter 32 vorgesehen, welche zwischen der Bodenplatte 30 und dem Halbleitersubstrat 10 angeordnet sind. Diese Abstandshalter 32 weisen in einer Richtung senkrecht zu der oberen (ersten) Oberfläche der Bodenplatte 30 eine Dicke auf, welche der gewünschten Dicke der Verbindungsschicht 26 entspricht. Die obere Oberfläche der Bodenplatte 30 ist dabei die Oberfläche, auf welcher das Halbleitersubstrat 10 angeordnet wird.

Das Halbleitersubstrat 10 kann dann an jeden der Abstandshalter 32 angedrückt werden. Der Zwischenraum zwischen der Bodenplatte 30 und dem Halbleitersubstrat 10 kann vollständig durch die Verbindungsschicht 26 ausgefüllt sein. Die Dicke der Verbindungsschicht 26 kann so auf einfache Art und Weise eingestellt werden. Die in Figur 2 dargestellten Abstandshalter 32 sind beispielsweise auf der Bodenplatte 30 aufgelötet oder auf andere Art und Weise mit der Bodenplatte 30 verbunden (z.B. mittels sogenanntem Drahtbonden).

Um das gesamte Verfahren zum Herstellen eines Halbleitermoduls zu vereinfachen ist gemäß dem in Figur 3 dargestellten Beispiel vorgesehen, die Abstandshalter direkt in die Bodenplatte 30 zu integrieren. Herkömmliche Bodenplatten 30 weisen entweder durchgehend die selbe Dicke auf, oder sie weisen eine sich von den Randbereichen zur Mitte hin kontinuierlich verringernde Dicke auf, wie in Figur 2A beispielhaft dargestellt (sog. D-Shape). Die Dicke wird dabei in einer Richtung senkrecht zu der oberen Oberfläche der Bodenplatte 30 gemessen, wobei die obere Oberfläche der Bodenplatte 30 diejenige Oberfläche ist, auf welcher das Halbleitersubstrat 10 angeordnet wird. Die in Figur 3 dargestellte Bodenplatte 30 weist im Wesentlichen eine gleichmäßige Dicke d30 auf. Die Bodenplatte 30 weist jedoch wenigstens eine Erhebung 34 auf. Im Bereich der wenigstens einen Erhebung 34 ist die Dicke d34 der Bodenplatte 30 lokal erhöht. Die Erhebungen 34 der Bodenplatte 30 aus Figur 3 haben die selbe Aufgabe wie die in Figur 2 dargestellten Abstandshalter 32. Das heißt, ein Halbleitersubstrat 10 wird derart auf der Bodenplatte 30 angeordnet, dass es auf den Erhebungen 34 aufliegt. Die Bereiche zwischen den Erhebungen 34 und zwischen der Bodenplatte 30 und dem Halbleitersubstrat 26 werden mit der Verbindungsschicht 26 gefüllt (Halbleitersubstrat 10 und Verbindungsschicht 26 in Figur 3 nicht explizit dargestellt). Eine Bodenplatte 30 mit integrierten Erhebungen 34 kann, wie in Figur 3 schematisch mit gestrichelter Linie dargestellt, ähnlich wie die in Figur 2 dargestellte Bodenplatte 30 jedoch auch eine gekrümmte untere Oberfläche aufweisen. Die Dicke d30 der Bodenplatte ist in diesem Fall nicht gleichmäßig, sondern verringert sich von den Randbereichen zur Mitte der Bodenplatte 30 hin. Im Bereich der wenigstens einen Erhebung 34 ist die Dicke d34 der Bodenplatte 30 ebenfalls lokal erhöht.

Die Erhebungen 34 in dem in Figur 3 dargestellten Beispiel sind somit einstückig mit der Bodenplatte 30 ausgebildet. Das heißt, die Erhebungen 34 werden direkt bei der Herstellung der Bodenplatte 30 mit hergestellt und nicht nachträglich als zusätzliche Elemente auf der Bodenplatte 30 aufgebracht (z.B. aufgelötet oder mittels Drahtbonden aufgebracht). Die Bodenplatte 30 kann beispielsweise ein metallisches Material aufweisen, z.B. Kupfer (Cu) oder Aluminium (Al). Bei derartigen Bodenplatten 30, welche durchgehend aus einem einzigen Material bestehen, können Erhebungen 34 leicht hergestellt werden, indem in den erforderlichen Bereichen während der Herstellung der Bodenplatte 30 mehr Material aufgebracht wird.

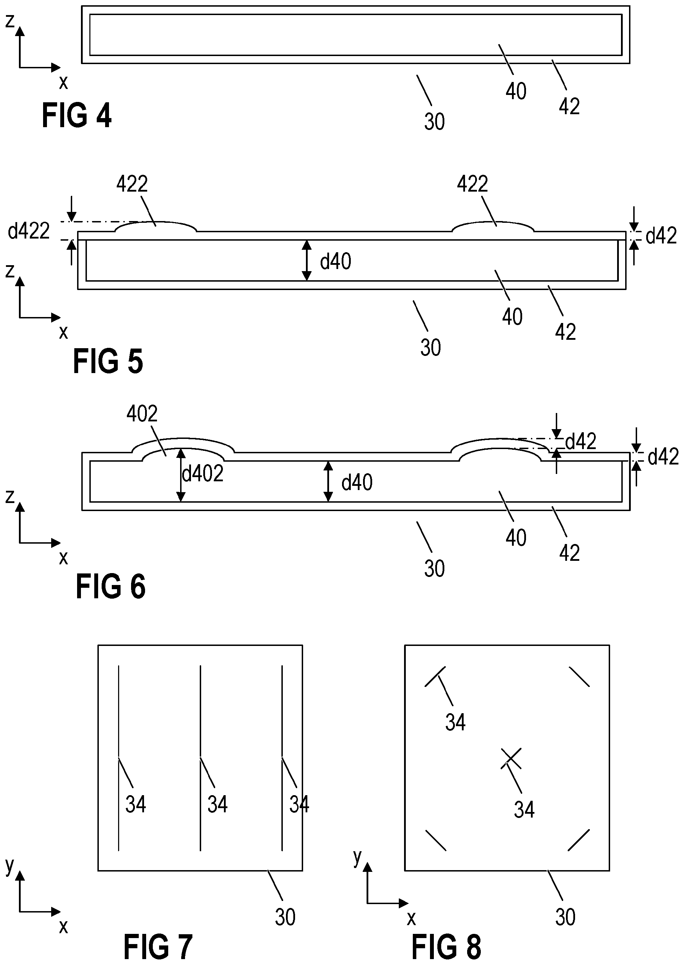

Heutzutage kommen jedoch auch sehr häufig Bodenplatten 30 zum Einsatz, welche aus mehreren verschiedenen Materialien bestehen, z.B. Aluminium-Siliziumkarbid-Bodenplatten (AlSiC-Bodenplatten). Eine solche Bodenplatte 30 ist beispielhaft in Figur 4 dargestellt. Die Bodenplatte 30 weist dabei eine erste Schicht 40 aus einem ersten Material, und eine zweite Schicht 42 auf, welche sowohl das erste als auch ein zweites Material aufweist. Die erste Schicht 40 bildet dabei einen Kern, welcher zu allen Seiten vollständig von der zweiten Schicht 42 umgeben ist. Die erste Schicht 40 weist beispielsweise SiC (Siliziumkarbid) auf. Die erste Schicht 40 kann eine poröse Schicht sein. Mittels Infiltration kann dann ein zweites Material, z.B. Aluminium (Al), in die Oberfläche dieser porösen Schicht eingebracht werden. Die zweite Schicht 42 kann daher sowohl SiC als auch Al aufweisen. Gemäß einem Beispiel erfolgt das Einbringen des zweiten Materials in die Oberfläche der porösen Schicht unter Druck.

Bei derartigen Bodenplatten 30 kann die wenigstens eine Erhebung 34 auf verschiedene Art und Weise hergestellt werden. Wie in Figur 5 dargestellt, kann die erste Schicht 40 beispielsweise durchgehend die selbe Dicke d40 aufweisen (oder eine sich von den Randbereichen zur Mitte hin verringernde Dicke, vgl. Figur 2A). Die zweite Schicht 42 kann im Wesentlichen eine zweite Dicke d42 aufweisen. Im Bereich der Erhebungen 34 kann die Dicke d422 der zweiten Schicht 42 jedoch lokal erhöht sein. Das heißt, im Bereich der Erhebungen 34 kann mehr von dem zweiten Material aufgebracht werden als in den restlichen Bereichen der zweiten Schicht 42.

Dies ist jedoch lediglich ein Beispiel. Gemäß einem weiteren Beispiel kann die erste Schicht 40 im Wesentlichen die erste Dicke d40 aufweisen (oder eine sich von den Randbereichen zur Mitte hin verringernde Dicke). Im Bereich der Erhebungen 34 kann die Dicke d402 der ersten Schicht 40 jedoch lokal erhöht sein. Das heißt, die Dicke d402 der ersten Schicht 40 verringert sich nicht kontinuierlich zur Mitte der Schicht hin, sondern weist Bereiche auf, in welchen die Dicke d402 sich kurzzeitig lokal erhöht. Die zweite Schicht 42 kann derart ausgebildet sein, dass sie durchgehend eine im Wesentlichen gleichmäßige Dicke d42 aufweist. Dies ist beispielhaft in Figur 6 dargestellt.

Die Erhebungen 34 können eine abgerundete Form aufweisen. Zum einen sind Erhebungen 34 mit abgerundeter Form leicht herstellbar, zum anderen können dadurch Beschädigungen an einem auf der Bodenplatte 30 aufgebrachten Halbleitersubstrat 10 durch Ecken oder Kanten vermieden werden.

Die Erhebungen 34 können an ihrer höchsten Stelle eine Dicke von zwischen 100µm (Mikrometer) bis 500µm, oder zwischen 150µm und 300µm aufweisen. Die Dicke der Erhebungen 34 ergibt sich aus der Differenz der maximalen Dicke d34 der Bodenplatte 30 im Bereich der Erhebung 34 und der ersten Dicke d30 der Bodenplatte 30 in den Bereichen der Bodenplatte 30 direkt neben den Erhebungen 34 (Dicke der Erhebung 34 = d34 - d30), vgl. Figur 3.

Wie bereits oben erläutert kann durch die Dicke der Erhebungen 34 die Dicke der Verbindungsschicht 26 eingestellt werden. Die Dicke der Verbindungsschicht 26 entspricht nach dem Verbinden der Bodenplatte 30 und des Halbleitersubstrats 10 der Dicke der Erhebungen 34. Durch eine minimale Dicke von beispielsweise 100µm oder 150µm kann eine ausreichende mechanische Verbindung zwischen Bodenplatte 30 und Halbleitersubstrat 10 häufig gewährleistet werden. In Abhängigkeit von den verschiedenen Parametern der Bodenplatte 30, der Verbindungsschicht 26 und des Halbleitersubstrats 10 (z.B. Material, Größe, etc.) kann jedoch möglicherweise auch bei geringeren Dicken bereits eine ausreichend stabile mechanische Verbindung hergestellt werden, oder es können größere Dicken erforderlich sein. Indem eine maximale Dicke nicht überschritten wird, kann gleichzeitig auch eine ausreichende thermische Verbindung zwischen Halbleitersubstrat 10 und Bodenplatte 30 gewährleistet werden. Die maximale Dicke kann beispielsweise 300µm oder 500µm betragen, je nach Parametern der Bodenplatte 30, der Verbindungsschicht 26 und des Halbleitersubstrats 10 (z.B. Material, Größe, etc.) kann dieser Wert jedoch auch größer oder kleiner gewählt werden.

Wie in den Draufsichten in den Figuren 7 und 8 dargestellt, kann die Bodenplatte 30 eine rechteckige oder quadratische Grundfläche aufweisen. Um eine gleichmäßige Dicke der Verbindungsschicht 26 zu gewährleisten, kann die Bodenplatte 30 beispielsweise wenigstens zwei Erhebungen 34 aufweisen. In dem in Figur 7 dargestellten Beispiel weisen die Erhebungen 34 eine langgestreckte Form auf. Das heißt, eine Abmessung der Erhebung 34 in einer ersten horizontalen Richtung x ist wesentlich geringer als eine Abmessung der Erhebung in einer zweiten horizontalen Richtung y. Beispielsweise kann sich eine solche Erhebung 34 in der zweiten horizontalen Richtung y über mindestens 50%, mindestens 75% oder mindestens 90% der gesamten Länge der Bodenplatte 30 in der selben Richtung erstrecken. Die Länge der Erhebung 34 kann dabei beispielsweise von der Größe des auf der Bodenplatte 30 anzuordnenden Halbleitersubstrats 10 abhängen. Wird auf einer Bodenplatte 30 mehr als ein Halbleitersubstrat 10 angeordnet, kann die Größe, Form und Anordnung der Erhebungen 34 entsprechend abweichen. Beispielsweise können für jedes Halbleitersubstrat 10 separate Erhebungen 34 vorgesehen werden. Wie unten in Bezug auf Figur 8 näher erläutert wird, können die Erhebungen 34 auch wesentlich kleiner bzw. kürzer sein, und auf beliebige geeignete Art und Weise auf der Bodenplatte 30 angeordnet sein.

Grundsätzlich kann das Vorsehen der beiden in Figur 7 dargestellten äußersten Erhebungen 34 bereits ausreichend sein, um eine gleichmäßige Dicke der Verbindungsschicht 26 zu gewährleisten. Eine weitere dritte Erhebung 34 zentral zwischen den beiden äußeren Erhebungen 34 kann jedoch verhindern, dass ein zentraler Bereich des Halbleitersubstrates 10 beispielsweise zu nah an die Bodenplatte 30 angedrückt wird. Die Anzahl der Erhebungen 34 kann dabei von verschiedensten Faktoren abhängen, wie beispielsweise der Größe, dem Material und der Dicke des Halbleitersubstrats 10.

Gemäß einem anderen, in Figur 8 schematisch dargestellten Beispiel kann die Bodenplatte 30 beispielsweise wenigstens vier Erhebungen 34 aufweisen, wobei im Bereich jeder der Ecken der Bodenplatte 30 eine Erhebung 34 angeordnet ist. Die Erhebungen 34 können eine längliche Form aufweisen (siehe Figur 8) oder auch punktförmig ausgebildet sein (nicht dargestellt). Auch bei diesem Beispiel kann, bei Bedarf, wenigstens eine weitere Erhebung 34 vorgesehen sein, welche beispielsweise in einem zentralen Bereich der Bodenplatte 30 angeordnet ist. In dem Beispiel in Figur 8 ist die zentrale Erhebung 34 kreuzförmig ausgebildet. Dies ist jedoch lediglich ein Beispiel. Jegliche andere geeignete Formen der Erhebungen 34 sind grundsätzlich möglich. Auch die in den Figuren 7 und 8 dargestellte Anzahl und die Anordnung der Erhebungen 34 sind lediglich beispielhaft. Die Erhebungen 34 können somit größer oder kleiner sein als die in den Figuren 7 und 8 dargestellten Erhebungen 34. Zudem können Erhebungen grundsätzlich jede beliebige Form aufweisen, welche dazu geeignet ist einen Abstand zwischen Halbleitersubstrat 10 und Bodenpatte 30 einzustellen.

Die in den Figuren 7 und 8 dargestellten Erhebungen stellen Beispiele für solche Fälle dar, in welchen nur ein einziges Halbleitersubstrat 10 auf der Bodenplatte 30 angeordnet wird. Wird mehr als ein Halbleitersubstrat 10 auf einer einzigen Bodenplatte 30 angeordnet, kann die Anzahl, Form und Anordnung der Erhebungen 34 entsprechend variieren. Beispielsweise könnten für jedes einzelne der Halbleitersubstrate 10 Erhebungen 34 vorgesehen werden, welche jeweils im Bereich der Ecken der Halbleitersubstrate 10 angeordnet sind. Die Größe, Form und Position der Erhebungen 34 auf der Bodenplatte 30 spielt für die vorliegende Erfindung grundsätzlich keine Rolle.

## Patentansprüche

1. Bodenplatte (30) für ein Halbleitermodul, wobei
die Bodenplatte (30) wenigstens eine Erhebung (34) aufweist,
die wenigstens eine Erhebung (34) einstückig mit der Bodenplatte (30) ausgebildet ist, und
die Bodenplatte (30) entweder eine gleichmäßige erste Dicke (d30) oder eine sich von den Randbereichen zur Mitte hin kontinuierlich verringernde Dicke (d30) aufweist, welche im Bereich jeder der wenigstens einen Erhebung (34) lokal bis zu einer maximalen zweiten Dicke (d34) erhöht ist.

2. Bodenplatte (30) nach Anspruch 1, wobei die Bodenplatte (30) weiterhin aufweist:
eine erste Schicht (40), die ein erstes Material aufweist;
eine zweite Schicht (42), die das erste und ein zweites Material aufweist, wobei die zweite Schicht (42) die erste Schicht (40) von allen Seiten vollständig umgibt.

3. Bodenplatte (30) nach Anspruch 2, wobei
die erste Schicht (40) entweder im Wesentlichen eine gleichmäßige dritte Dicke (d40), oder eine Dicke (d40) aufweist, welche sich von den Randbereichen der ersten Schicht (40) zur Mitte der ersten Schicht (40) hin kontinuierlich verringert;
die Dicke der ersten Schicht (40) im Bereich der wenigstens einen Erhebung (34) bis zu einer maximalen vierten Dicke (d402) lokal erhöht ist; und
die zweite Schicht (42) eine fünfte Dicke (d42) aufweist.

4. Bodenplatte (30) nach Anspruch 2, wobei
die erste Schicht (40) eine dritte Dicke (d40) oder eine sich von den Randbereichen zur Mitte hin kontinuierlich verringernde Dicke (d40) aufweist;
die zweite Schicht (42) im Wesentlichen eine vierte Dicke (d42) aufweist; und
die Dicke der zweiten Schicht (42) im Bereich der wenigstens einen Erhebung (34) bis zu einer maximalen fünften Dicke (d422) lokal erhöht ist.

5. Bodenplatte (30) nach einem der Ansprüche 2 bis 4, wobei
das erste Material Siliziumkarbid aufweist; und
das zweite Material Aluminium aufweist.

6. Bodenplatte (30) nach einem der vorhergehenden Ansprüche, wobei die wenigstens eine Erhebung (34) an ihrer höchsten Stelle eine maximale Dicke von zwischen 100µm und 500µm, oder zwischen 150µm und 300µm aufweist, wobei sich die maximale Dicke der Erhebung (34) aus der Differenz aus der maximalen zweiten Dicke (d34) und der ersten Dicke (d30) der Bodenplatte (30) direkt neben der entsprechenden Erhebung (34) ergibt.

7. Bodenplatte (30) nach einem der vorhergehenden Ansprüche, wobei die Bodenplatte (30) eine rechteckige oder quadratische Grundfläche und wenigstens zwei Erhebungen (34) aufweist.

8. Bodenplatte (30) nach Anspruch 7, wobei im Bereich jeder von vier Ecken der Bodenplatte (30) eine Erhebung (34) angeordnet ist.

9. Bodenplatte (30) nach Anspruch 8, wobei jede der Erhebungen (34) eine längliche Form aufweist oder punktförmig ausgebildet ist.

10. Bodenplatte (30) nach Anspruch 7, wobei jede der wenigstens zwei Erhebungen (34) eine Abmessung in einer ersten horizontalen Richtung (x) aufweist die wesentlich kleiner ist als eine Abmessung der selben Erhebung (34) in einer zweiten horizontalen Richtung (y), senkrecht zu der ersten horizontalen Richtung (x).

11. Verfahren das Aufweist:
Herstellen einer Bodenplatte (30) mit einer gleichmäßigen ersten Dicke (d30) oder einer sich von den Randbereichen zur Mitte hin kontinuierlich verringernden Dicke (d30); und
lokales Erhöhen der ersten Dicke (d30) bis zu einer maximalen zweiten Dicke (d34) im Bereich wenigstens einer Erhebung (34), wobei
die wenigstens eine Erhebung (34) einstückig mit der Bodenplatte (30) ausgebildet ist.

12. Verfahren nach Anspruch 11, wobei das Herstellen der Bodenplatte (30) aufweist:
Herstellen einer ersten Schicht (40) die ein erstes Material aufweist, wobei die erste Schicht (40) eine gleichmäßige dritte Dicke (d40) oder eine sich von den Randbereichen zur Mitte hin kontinuierlich verringernde Dicke (d40) aufweist; und
Herstellen einer zweiten Schicht (42) die das erste und ein zweites Material aufweist, wobei
die erste Schicht (40) einen Kern bildet, welcher zu allen Seiten vollständig von der zweiten Schicht (42) umgeben ist, und
die zweite Schicht (42) eine vierte Dicke (d42) aufweist, welche im Bereich der wenigstens einen Erhebung (34) bis zu einer maximalen fünften Dicke (d422) lokal erhöht ist.

13. Verfahren nach Anspruch 11, wobei das Herstellen der Bodenplatte (30) aufweist:
Herstellen einer ersten Schicht (40) die ein erstes Material aufweist, wobei die erste Schicht (40) eine gleichmäßige dritte Dicke (d40) oder eine sich von den Randbereichen zur Mitte hin kontinuierlich verringernde Dicke (d40) aufweist, welche im Bereich der wenigstens einen Erhebung jeweils bis zu einer maximalen vierten Dicke (d402) erhöht ist; und
Herstellen einer zweiten Schicht (42) die das erste und ein zweites Material aufweist, wobei
die erste Schicht (40) einen Kern bildet, welcher zu allen Seiten vollständig von der zweiten Schicht (42) umgeben ist, und
die zweite Schicht (42) durchgehend eine fünfte Dicke (d42) aufweist.

14. Verfahren nach Anspruch 12 oder 13, wobei das Herstellen der zweiten Schicht (42) weiterhin das Einbringen des zweiten Materials in eine poröse Oberfläche der ersten Schicht (40) aufweist.

15. Anordnung mit:
wenigstens einem Substrat (10);
einer Verbindungsschicht (26); und
einer Bodenplatte (30) gemäß einem der Ansprüche 1 bis 10, wobei
das wenigstens eine Substrat (10) auf der Bodenplatte (30) angeordnet ist, und
die Verbindungsschicht (26) zwischen dem wenigstens einen Substrat (10) und der Bodenplatte (30) angeordnet ist und diese miteinander verbindet.
